Europäisches Patentamt

European Patent Office

Office européen des brevets

(19)

(11) Numéro de publication : **0 089 275**
**B1**

(12) FASCICULE DE BREVET EUROPÉEN

(45) Date de publication du fascicule du brevet :
28.05.86

(51) Int. Cl.⁴ : **G 01 R 15/07**

(21) Numéro de dépôt : 83400467.3

(22) Date de dépôt : 07.03.83

(54) Dispositif interferométrique de mesure de courant électrique à fibres optique.

(30) Priorité : 12.03.82 FR 8204222
14.05.82 FR 8208482

(43) Date de publication de la demande :
21.09.83 Bulletin 83/38

(45) Mention de la délivrance du brevet :
28.05.86 Bulletin 86/22

(84) Etats contractants désignés :
BE DE FR GB IT NL SE

(56) Documents cités :
EP-A- 0 023 180
DE-A- 2 716 922
DE-A- 2 901 872
DE-B- 2 433 432
FR-A- 2 258 633

(73) Titulaire : **THOMSON-CSF**
**173, Boulevard Haussmann**
**F-75379 Paris Cedex 08 (FR)**

(72) Inventeur : **Arditty, Hervé**
**THOMSON-CSF SCPI 173, bld Haussmann**
**F-75379 Paris Cedex 08 (FR)**
Inventeur : **Rollin, Michel**
**THOMSON-CSF SCPI 173, bld Haussmann**
**F-75379 Paris Cedex 08 (FR)**

(74) Mandataire : **Lepercque, Jean et al**
**THOMSON-CSF SCPI 19, avenue de Messine**
**F-75008 Paris (FR)**

EP 0 089 275 B1

Jouve, 18, rue St-Denis, 75001 Paris, France

## Description

La présente invention se rapporte au domaine de la mesure des courants électriques et plus particulièrement des courants de très fortes intensités véhiculés par des lignes hautes tensions.

La mesure de courants ayant de fortes intensités et susceptible de varier dans de grandes proportions est difficile avec les dispositifs de mesure habituels, dans certains environnements, particulièrement dans les centrales électriques ou les usines d'électrochimie. En effet, dans de tels environnements, les fortes tensions, les températures élevées, l'atmosphère éventuellement corrosive, la pollution électromagnétique ou tout simplement l'accessibilité difficile rendent les mesures difficiles et peu fiables lorsqu'elles sont effectuées par des moyens classiques du type shunt ou jauge à effet Hall par exemple. Ainsi, pour mesurer des courants de l'ordre d'une centaine de milliers d'ampères, les dispositifs de mesure de courant type shunt ne permettent d'obtenir qu'une précision de l'ordre de 10 % de la valeur mesurée. De plus, de tels dispositifs entraînent des pertes d'énergie dans le dispositif de mesure.

Pour améliorer ces dispositifs, il a été proposé de mettre à profit l'effet magnétooptique qui se manifeste par exemple dans les dispositifs du type interféromètre. Comme il est connu, lorsqu'une onde lumineuse se propage parallèlement aux lignes de force d'un champ magnétique, celui-ci induit sur l'onde un effet non réciproque appelé effet Faraday.

La demande de brevet européen EP-A-0 023 180 concerne un dispositif interférométrique de mesure de courant électrique à fibre optique de ce type.

Le dispositif décrit dans ce brevet comporte une fibre optique enroulée autour du conducteur dans lequel circule le courant à mesurer, une source laser, des moyens de séparation du rayonnement émis par la source vers les deux extrémités de la fibre enroulée et de recombinaison du rayonnement émergeant de ces deux extrémités, un circuit conducteur parcouru par un courant de référence réglable, un dispositif de détection fournissant un signal caractéristique des interférences entre les deux ondes émergeant de la fibre, le courant de référence étant ajusté pour que le déphasage entre les deux ondes contrarotatives dans la fibre soit nul, ce courant étant alors proportionnel au courant à mesurer circulant dans le conducteur principal.

Cependant lorsqu'on mesure des courants transportés par des lignes de distribution hautes ou très hautes tensions, ces tensions atteignant couramment 220 KV ou même 400 KV, les distances d'isolement dans l'air sont respectivement 2,5 m et 4,5 m. Il n'est donc pas possible d'entourer simplement le conducteur véhiculant le courant par une ou plusieurs spires de la fibre optique de l'interféromètre et disposer à proximité les circuits électroniques fournissant le courant de référence réglable.

Il est connu par la demande de brevet DE-A-2 901 872 un arrangement d'isolation haute tension comprenant une fibre optique pour la transmission d'informations ou de données. Cet arrangement comprend une tête de mesure enfilée sur un conducteur et associé à chaque tête de mesure, un élément en matériau isolant percé d'un canal de liaison, l'une des extrémités de ce canal débouchant dans la tête de mesure, et une embase portée au potentiel de la terre elle-même associée à un dispositif de saisie de mesure portée à un faible potentiel et communiquant avec la seconde extrémité du canal percé dans l'élément isolant. Cet arrangement permet d'isoler la tête de mesure du sol et sert de gaine de protection pour la fibre optique.

D'autres difficultés apparaissent également. De façon plus précise, le dispositif interférométrique sus-mentionné fonctionne en réducteur de courant. Les circuits électroniques ajustent le courant dans l'enroulement de contre-réaction de façon à annuler l'effet du courant parcourant la boucle principale sur la phase de la lumière guidée par la fibre. Les deux courants sont alors en proportion du nombre de tours des enroulements seulement si le coefficient d'interaction magnétooptique est le même pour les deux enroulements, l'un de ceux-ci étant réduit à sa plus simple expression puisqu'il s'agit du câble de transport d'énergie.

Lorsque ces deux enroulements ne sont pas superposés, c'est le cas le plus général, l'application du théorème d'Ampère, qui garantit cette égalité, n'est possible que si l'état de polarisation de la lumière véhiculée est uniforme le long du parcours fermé de la fibre de l'interféromètre.

Aucune fibre ne conserve parfaitement l'état de polarisation circulaire nécessaire à ce fonctionnement. Lorsque, comme c'est le cas pour l'utilisation en très haute tension, on est conduit à éloigner considérablement la boucle de contre-réaction du conducteur de courant principale pour éviter un amorçage, la stabilité du facteur d'échelle peut en être affectée considérablement et la mesure faussée.

L'invention se fixe pour but de pallier les difficultés rencontrées avec les dispositifs de l'art connu.

L'invention a donc pour objet un dispositif de mesure du courant circulant dans une ligne de distribution d'énergie électrique portée à un potentiel élevé par rapport au potentiel de la terre, tel que spécifié dans les revendications 1 ou 7.

L'invention sera mieux comprise et d'autres caractéristiques apparaîtront au moyen de la description qui suit par référence aux figures qui l'accompagnent et parmi celles-ci :

Les figures 1 à 3 sont relatives à un dispositif interférométrique de mesure de courant de l'art connu.

La figure 4 est un exemple de réalisation concrète d'un dispositif selon une première approche de l'invention.

Les figures 5 à 8 sont des figures de détails d'éléments particuliers mis en œuvre dans le dispositif de la figure 4.

Les figures 9 et 10 illustrent un exemple de réalisation concrète d'un dispositif de mesure selon une seconde approche de l'invention.

La figure 11 illustre un détail de réalisation d'un tel dispositif.

Les figures 12 et 13 illustrent l'application du dispositif de l'invention à la mesure de courants polyphasés.

Le dispositif de l'invention mettant en œuvre un organe de mesure de courant comprenant un interféromètre à fibre optique, il est utile d'en rappeler le fonctionnement.

Le courant circulant dans un conducteur induit un champ magnétique autour de ce conducteur. Si une onde lumineuse se propage dans un milieu entourant ce conducteur, le champ magnétique induit, par effet magnétooptique, des variations dans les conditions de propagation de l'onde lumineuse. Lorsque le champ magnétique et la direction de propagation de l'onde lumineuse sont parallèles, l'effet magnétooptique induit sur l'onde lumineuse est un effet non réciproque ou effet Faraday, dépendant du sens de propagation de l'onde par rapport au sens du champ magnétique.

Pour mettre en évidence par cet effet non réciproque une quantité mesurable qui soit directement liée au courant circulant dans le conducteur, et qui par conséquent n'intègre pas d'autres effets et en particulier les effets réciproques produisant eux aussi des variations dans les conditions de propagation, (variation de température ou variation de pression par exemple), l'organe de mesure utilise deux ondes contrarotatives dans le même milieu de propagation entourant le conducteur ; ces deux ondes subissent de la même manière les effets réciproques induisant dans le milieu des variations dans les conditions de propagation variant dans le même sens, et subissent par effet Faraday non réciproque des variations en sens contraires. Ces variations en sens contraires sont susceptibles d'être détectées par une méthode interférométrique.

Pour cela, l'organe de mesure de courant comporte une fibre optique enroulée autour du conducteur dans lequel circule le courant I à mesurer, cette fibre optique comportant une ou plusieurs spires, les deux extrémités de cette fibre optique enroulée recevant chacune une onde optique issue par exemple d'un laser ; ces deux ondes circulent en sens contraires dans la fibre. Le courant circulant dans le conducteur induit un champ magnétique dans le même sens que le sens de propagation de l'une des ondes et en sens contraire de l'autre. Les deux ondes émergeant de la fibre présentent un déphasage $\Delta\Phi$ qui dépend de la constante de Verdet caractéristique de l'effet Faraday du milieu de propagation, de l'intensité I du courant circulant dans le conducteur, (éventuellement du nombre q de conducteurs lorsque la fibre optique entoure plusieurs branches de conducteur dans lequel circule le même courant I), et du nombre m de tours de la fibre optique entourant le conducteur.

Pour mettre en évidence le déphasage entre les deux ondes, l'organe de mesure met en œuvre une structure d'interféromètre, les deux ondes contrarotatives émergeant des extrémités de la fibre étant recombinées et le signal correspondant étant détecté par un photodétecteur.

Compte tenu des différentes constantes intervenant dans le dispositif, et des variations dans le temps susceptibles de se produire, il est très difficile de connaître le facteur d'échelle d'un tel dispositif de mesure, c'est-à-dire la relation liant l'intensité I du courant circulant dans le conducteur et l'intensité lumineuse L détectée sur le photodétecteur. En conséquence, dans les modes de réalisation préférés l'organe de mesure met en œuvre une méthode de zéro pour effectuer cette mesure. Pour cela la fibre optique, et donc l'onde optique, subissent les effets d'un champ magnétique de référence produit par un courant i très inférieur au courant à mesurer parcourant un conducteur passant un grand nombre de fois par la boucle de fibre optique. Le courant i est réglable et ajusté à tout moment pour compenser le déphasage $\Delta\Phi$ induit par le courant I en créant un déphasage $\Delta\Phi$ induit par le courant i.

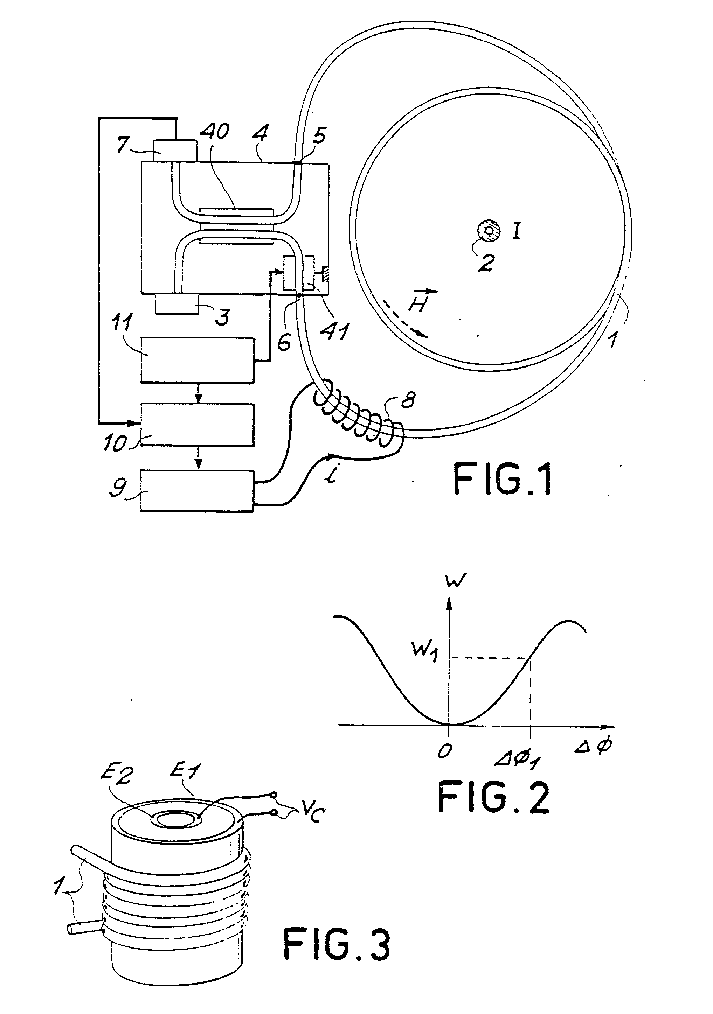

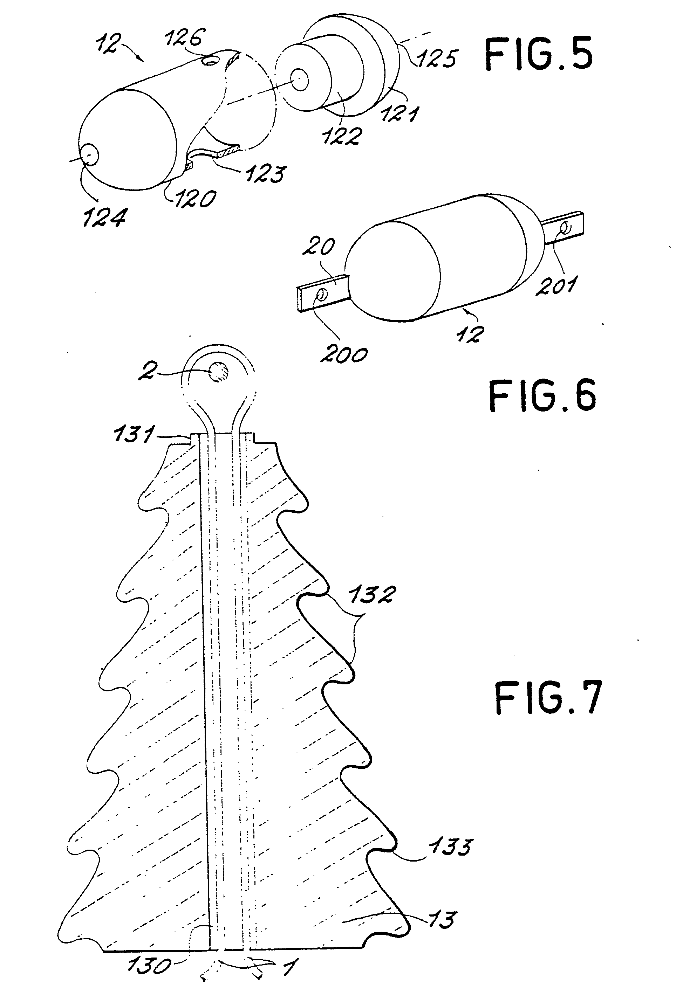

De nombreuses variantes de réalisation de l'organe de mesure peuvent être mises en œuvre dans le cadre de l'invention et parmi celles-ci, pour fixer les idées, la variante de réalisation représentée sur la figure 1 va être décrite, variante correspondant à celle décrite en relation avec la figure 5 de la demande de brevet EP-A-0 023 180.

Une fibre 1 forme une ou plusieurs spires autour d'un conducteur 2, suivant la gamme de courant à mesurer. Un faisceau lumineux issu d'un laser 3 est couplé simultanément aux deux extrémités de la fibre 1 par l'intermédiaire d'un circuit optique de séparation et de couplage 4. Les deux ondes lumineuses circulent dans la fibre en sens contraites, émergent par les deux extrémités 5 et 6 pour se recombiner dans le circuit optique de séparation et de couplage. Le rayonnement résultant du mélange des ondes émergentes est détecté par un photodétecteur 7. Lorsque le conducteur 2 est parcouru par un courant I, il induit un champ magnétique $\vec{H}$ suivant des lignes fermées autour de ce conducteur. L'onde lumineuse se propageant dans la fibre subit, sur ses composantes de polarisation circulaire, un déphasage induit par effet Faraday par le champ magnétique. On sait qu'une fibre optique se comporte comme un empilement de lames biréfringentes quelconques induisant sur l'onde lumineuse qui se propage des variations de polarisation. Ces effets sont réciproques et agissent sur les deux ondes contrarotatives de la même manière ; par contre l'effet de polarisation circulaire pour introduire une avance ou un retard sur chacune des composantes, agit dans des sens différents sur les deux ondes contrarotatives et introduit donc entre elles un déphasage global $\Delta\Phi$. En effet pour chaque onde l'établissement du champ magnétique parallèle à la direction de propagation avance la vibration circulaire dans le même sens que le courant magnétisant et retarde d'une quantité égale la vibration circulaire en sens contraire. Même si l'état de polarisation de l'onde lumineuse varie au cours de la propagation le long de la fibre, les effets d'avance et de retard se cumulent le long de cette fibre et les deux ondes émergentes présentent un déphasage susceptible d'être détecté par interférométrie représentant directement les effets induits par le courant I circulant dans le conducteur, les autres effets étant subis de manière identique par les deux ondes et n'introduisant donc pas entre elles de déphasage.

L'organe de mesure représenté fournit sur le détecteur une intensité lumineuse W qui varie en fonction du déphasage $\Delta\Phi$ entre les deux ondes contrarotatives suivant la courbe représentée sur la figure 2, le déphasage étant fonction du courant I circulant dans le conducteur. Mais, du fait des variations subies par les ondes dans la fibre en fonction du temps, le facteur d'échelle de cette courbe n'est pas fixe dans le temps, c'est-à-dire que l'intensité lumineuse $W_1$ détectée pour un déphasage induit $\Delta\Phi_1$ fixé, dû à un courant donné $I_1$, peut varier en fonction du temps. Ce dispositif de mesure ne permet donc pas de fournir une mesure absolue du courant I.

L'organe de mesure représenté sur la figure 1 met en œuvre une méthode de zéro permettant à chaque instant de disposer d'une valeur de référence i ajustée pour produire un déphasage entre les deux ondes contrarotatives par effet Faraday compensant exactement le déphasage induit par le courant I à mesurer, ce courant i étant alors directement proportionnel au courant I à mesurer. L'organe de mesure comporte pour ce faire un conducteur 8 comportant p spires entourant une (ou plusieurs) spire de la fibre optique enroulée 1. Ce conducteur 8 est parcouru par un courant variable i délivré par un générateur de courant 9. Le signal issu du photodétecteur 7 correspondant aux interférences entre les deux ondes contrarotatives émergeant de la fibre, est transmis à un dispositif de traitement 10 qui fournit au générateur de courant 9 un signal de commande tel qu'à chaque instant le déphasage entre les deux ondes contrarotatives soit nul.

Si K est la constante de Verdet du matériau formant la fibre, m étant le nombre de spires enroulées autour du conducteur 2, q étant le nombre de branches du conducteur entouré par cette fibre enroulée 1, le déphasage $\Delta\Phi_1$ induit par le courant I circulant dans le conducteur 2 est :

$$\Delta\Phi_1 = KmqI. \tag{1}$$

Si p est le nombre de spires du conducteur 8 entourant n spires de la fibre optique 1, le déphasage 2 induit par le courant i circulant dans le conducteur 8 est :

$$\Delta\Phi_2 = Kpni. \tag{2}$$

Le circuit de traitement 10 applique au générateur de courant un signal de commande tel qu'à chaque instant $\Delta\Phi_1 = -\Delta\Phi_2$, le déphasage entre les deux ondes contrarotatives étant ainsi maintenu égal à zéro à tout moment. La valeur du courant I se déduit alors de la valeur du courant i par la relation

$$I = \frac{pn}{mq} i.$$

Pour obtenir un organe de mesure ayant une résolution importante, plusieurs méthodes sont envisageables. La première (non représentée) consiste à moduler le courant circulant dans le conducteur de référence 8 et à effectuer ensuite une détection hétérodyne à la fréquence de modulation de ce courant, le signal issu de cette détection hétérodyne permettant d'asservir la composante continue du courant circulant dans le conducteur 8. Une deuxième méthode consiste à moduler directement la phase de l'onde circulant dans la fibre optique 1. Pour ce faire, on utilise également le circuit optique intégré 4 qui va maintenant être décrit de façon plus détaillée.

Le circuit optique intégré 4 est alimenté par une source laser à semiconducteur 3 directement couplée par la tranche à la plaquette de circuit intégré. Un coupleur à 3 dB, 40, permet de séparer le faisceau lumineux issu de la source laser 3 entre deux branches de guide optique intégré, ces deux branches étant respectivement couplées aux deux extrémités 5 et 6 de la fibre optique enroulée 1. Le dispositif comporte en outre pour la détection des ondes émergeant après circulation en sens contraires un détecteur 7 détectant le rayonnement résultant de la superposition des deux ondes par le coupleur 40. Le signal de sortie de ce détecteur est appliqué à un circuit de traitement de signal 10 fournissant au générateur de courant 9 un signal de commande permettant de faire varier le courant i circulant dans le conducteur 8 entourant la fibre optique.

Pour moduler la phase de l'onde guidée, la structure optique intégrée est particulièrement adaptée car il est possible de réaliser de manière simple un modulateur de phase placé dans le circuit optique intégré sur l'un des deux guides d'onde disposés à la sortie du coupleur 3 dB. Ce modulateur de phase 41 a été représenté schématiquement sur la figure 1.

Le déphasage entre les deux ondes émergeant des deux extrémités de la fibre est modulé au rythme d'une pulsation de fréquence F au moyen d'un générateur de signal de modulation. Le circuit de traitement 10 comprend donc dans un tel cas un détecteur hétérodyne recevant un signal de référence à la fréquence F et fournissant au générateur de courant 9 un signal de commande.

De manière à rendre cette modulation réciproque, il est possible d'utiliser le même modulateur de phase électrooptique intégré commandé par un signal de modulation de période égale à deux fois le temps de parcours de la fibre par l'onde optique. En effet, lorsque la différence de phase entre les deux ondes contrarotatives due à l'effet Faraday est nulle, et que seule existe une différence de phase due à la modulation, le signal détecté comporte une composante à la fréquence double de la fréquence de modulation. La détection de cette composante à fréquence double qui existe seule lorsque $\Delta\Phi = 0$ permet donc de déterminer sans ambiguïté la valeur du courant i de référence pour laquelle l'effet Faraday induit par le courant I est exactement compensé. Dans un dispositif à éléments discrets, il est également possible de moduler la phase de l'onde se propageant dans la boucle de fibre de manière réciproque. Pour cela un modulateur de phase, qui peut être réalisé en enroulant quelques spires de fibre autour d'une céramique piézoélectrique, dont la période de modulation est égale à deux fois le temps de parcours dans la boucle de fibre permet d'obtenir par détection de la composante à fréquence double le courant i annulant l'effet Faraday.

Un exemple d'un tel modulateur de phase est illustré schématiquement par la figure 3. Ce modulateur est constitué par un cylindre creux en matériau piézoélectrique excité par deux électrodes $E_1$ et $E_2$, déposées recpectivement sur les faces externe et interne du cylindre et recevant le signal de commande $V_c$ à la fréquence double. On a enroulé en spires serrées l'une des extrémités de la fibre constituant l'anneau de l'interféromètre. Les déformations du matériau piézoélectrique induites par le signal périodique $V_c$ sont transmises à la fibre optique et ont pour conséquence de moduler périodiquement la phase des ondes circulant en sens inverses dans la fibre.

L'invention va utiliser comme organe de base pour la mesure de courant, un organe interférométrique à fibre optique du type qui vient d'être décrit ou d'un type analogue. En particulier, le circuit optique intégré 4 peut être d'un autre type ou être remplacé par des éléments discrets plus classiques analogues à ceux décrits en relation avec la figure 3 du brevet français précité.

Cependant, comme il a été rappelé, lorsqu'il s'agit de mesurer des courants véhiculés par des lignes hautes ou très hautes tensions, la structure d'un dispositif de mesure ne peut être dérivée simplement de la configuration schématique qui vient d'être redécrite. L'invention se fixe pour but une structure de dispositif adaptée à ce type d'applications.

Pour fixer les idées, sans que cela soit limitatif, on se placera dans ce qui suit dans le cadre de l'application de la mesure, en poste fixe, du courant véhiculé par les lignes hautes tensions : 220 KV ou 400 KV. Le dispositif de mesure est alors destiné à remplacer les transformateurs réducteurs de courants classiquement utilisés pour ce type d'application.

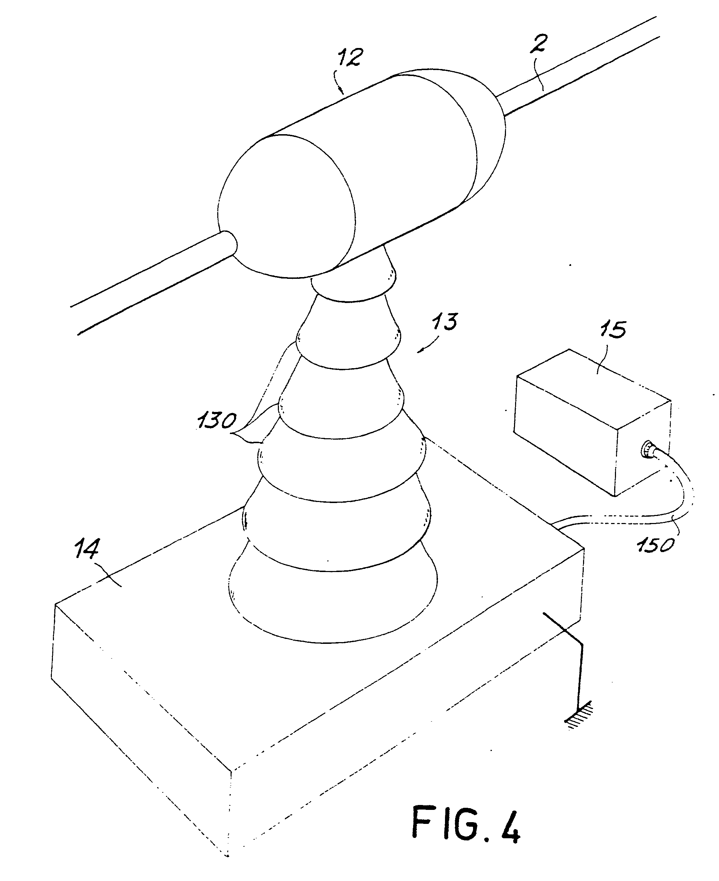

Le dispositif selon l'invention comprend de façon préférentielle quatre parties comme représenté sur la figure 4 :

— la tête de mesure 12 contenant un mandrin sur lequel la fibre optique est enroulée de la manière qui sera décrite plus en détail dans ce qui suit. Cette tête comporte un passage axial suffisant pour qu'elle puisse être enfilée sur le câble 2 dans lequel circule le courant à mesurer. Le câble 2 est entouré d'au moins une spire de fibre optique conformément à la disposition de la figure 1. Cette partie du dispositif de mesure est au même potentiel que la ligne 2, c'est-à-dire à un potentiel élevé par rapport à la terre.

— le support 13 : c'est une partie de forme générale cylindrique ou tronconique qui supporte la tête du capteur et protège les fibres de connexion.

On peut réaliser cet élément à partir d'un isolateur percé dans sa longueur ou d'une céramique d'extrémité, creuse par construction. Selon les réalisations, cet isolateur supporte seulement la tête 12, ou bien supporte, par l'intermédiaire de la tête, une partie de la charge de la ligne de courant 2. Il est donc dimensionné en conséquence.

Dans le cadre de lignes hautes tensions 220 KV ou 400 KV, les distances d'isolement dans l'air sont respectivement 2,5 m et 4,5 m. La longueur du support 13 doit être supérieure à ces valeurs. Pour 400 KV, on choisit typiquement cette longueur égale à 5 m. De façon plus générale la longueur du support isolant doit être plus grande que la distance de contournement de l'isolateur qui dépend de sa géométrie.

— la base 14 du dispositif : elle est reliée au potentiel de la terre et est destinée à supporter le support 13 et à abriter l'enroulement de contre-réaction 8. Sa forme peut être quelconque ainsi que le matériau qui la constitue. De façon préférentielle, elle est constituée en métal magnétique, par exemple du mu-métal qui permet un meilleur découplage vis-à-vis des champs magnétiques extérieurs susceptibles de créer des phénomènes parasites.

— une baie d'électronique et d'optique 15 : reliée par un câble souple comportant à la fois des fibres optiques et des conducteurs, elle peut abriter le cœur optique de l'interféromètre et l'électronique de traitement et d'exploitation des signaux électriques.

Dans une variante préférée le cœur optique de l'interféromètre est également situé dans la base du capteur, ce qui permet la jonction par un câble 150 comportant seulement des conducteurs électriques.

Enfin, dans une variante non représentée, la baie électronique 15 peut également être confondue avec la base 14 du capteur.

Dans une variante de réalisation pratique de la tête de mesure 12, représentée en coupe partielle sur la figure 5, celle-ci peut être constituée originellement par deux demi-coques, 120 et 121, respectivement femelle et mâle. La partie mâle comporte un mandrin central 122 ou un élément analogue sur lequel est enroulée au moins une spire de la fibre optique 1 (non représentée sur la figure 5).

La partie femelle comporte un orifice 123 destiné à être enfilé sur l'extrémité du support 13. Les deux demi-coques 121 et 122 sont percées chacune par un canal axial débouchant respectivement aux extrémités 124 et 125 de manière à ce que la tête de capteur puisse être enfilée sur le câble 2 (figure 4).

Les deux demi-coques sont ensuite assemblées et peuvent être remplies par un orifice 116 d'un matériau isolant, par exemple de la résine époxy fixant le tout. Le matériau composant les demi-coques est également un matériau isolant, par exemple de la céramique de même nature que celle composant le support isolant 13.

Le diamètre d'enroulement de la fibre, c'est-à-dire celui du mandrin 122, est choisi de façon à ne pas causer une atténuation trop forte au passage de la lumière et pour ne pas perturber exagérément l'état de polarisation (circulaire) de la lumière véhiculée.

La tête de mesure 12 présente des surfaces convexes à grands rayons de courbures pour éviter des gradients de champ électrique susceptibles de créer des amorçages (effet corona). A titre d'exemple, elle peut se présenter sous la forme d'un cylindre prolongé à ses extrémités par deux demi-sphères, comme représenté sur les figures 4 et 5, ou sous la forme d'un tore d'axe confondu avec le câble 2.

Alternativement, comme représenté sur la figure 6, la tête de mesure 12 peut comporter d'origine une barre 20 solidaire de celle-ci et destinée à être insérée en série dans la ligne véhiculant le courant à mesurer. Pour ce faire, des moyens de connexions, représentés sur la figure 6 par des orifices 200 et 201 percés dans la barre, sont prévus. Dans cet exemple de réalisation la barre peut être fixée par boulonnage.

Le support isolant 13 est représenté en coupe sur la figure 7. Il comprend un canal par exemple de section circulaire 130 dans lequel la fibre 1 effectue au moins un aller et retour de manière à former au moins une spire autour du câble 2. Le support se prolonge par une collerette 131 destinée à s'emboîter dans l'orifice 123 de la tête de mesure (figure 5).

Pour améliorer la tenue diélectrique et la résistance à l'environnement, l'extérieur de l'isolateur 13 peut présenter une succession de jupes 132 destinées à accroître la longueur de la ligne de fuite munies de « gouttes d'eau » 133 aux extrémités. Pour la même raison, l'intérieur peut être rempli d'huile ou de gaz sous pression par exemple de l'hexafluorure de soufre ($SF_6$). Dans ce cas la longueur de l'isolateur 12 peut être réduite. Pour le gaz la proportion de réduction est de l'ordre d'un facteur dix. Cependant, bien que séduisante, cette solution nécessite la mise en œuvre de dispositions aptes à garantir une parfaite étanchéité, y compris au niveau de la tête de mesure. Tous les orifices doivent être scellés, ce qui rend plus complexe et onéreuse la construction du dispositif de l'invention.

Dans une autre variante (non représentée) les fibres optiques peuvent être maintenues dans un tube en matériau isolant.

Enfin, l'ensemble peut être moulé de façon analogue à ce qui a été décrit pour la tête de mesure dans de la résine époxy remplissant l'intérieur du canal axial 120 et scellant les fibres optiques.

Bien qu'une seule spire de la fibre optique entourant le câble 2 soit suffisante pour que l'effet Faraday se manifeste, comme il a été rappelé, il est nécessaire que l'état de polarisation se conserve parfaitement tout au long de la fibre optique 1. Or aucune fibre optique conserve intact cet état de polarisation, notamment dans le cadre d'applications de la présente invention pour lesquelles la distance séparant le conducteur principal, c'est-à-dire la ligne 2, de l'enroulement de référence 8 est particulièrement importante, au minimum la longueur de la fibre optique est égale à deux fois la longueur du support isolant 13.

Dans ce cas les formules (1) et (2) précédemment rappelées deviennent respectivement :

$$\Delta\Phi_1 = Kmql \qquad\qquad (1\,bis)$$

$$\Delta\Phi_2 = K'\,pni \qquad\qquad (2\,bis)$$

avec $K \neq K'$.

Aussi dans une variante de réalisation préférée et selon un autre aspect avantageux de l'invention, des dispositions particulières sont prises pour contrecarrer cet effet parasite.

Selon cet aspect de l'invention, la dérive de polarisation est réduite en effectuant une moyenne spatiale sur l'évolution de la polarisation.

Pour ce faire, de façon préférentielle, la fibre 1 de l'interféromètre est disposé selon le schéma de câblage suivant :

a) départ du cœur de l'interféromètre,
b) montée vers la tête de mesure 12 par le canal 130 de l'isolateur 13,
c) passage autour du câble 2, ce qui correspond à une spire de fibre optique,
d) descente vers la base 14,
e) bobinage de n spires sur la bobine de contre-réaction,
f) répétition des étapes b), c), d), e) m fois,
g) retour vers le cœur de l'interféromètre.

Dans ce qui précède, le départ du cœur de l'interféromètre est l'extrémité 5 du circuit intégré optique 4, si on se reporte à la configuration représentée sur la figure 1, et le retour s'effectue sur l'extrémité 6. De façon préférentielle, comme il a été précédemment indiqué le cœur de l'interféromètre est situé dans la base 14 du dispositif.

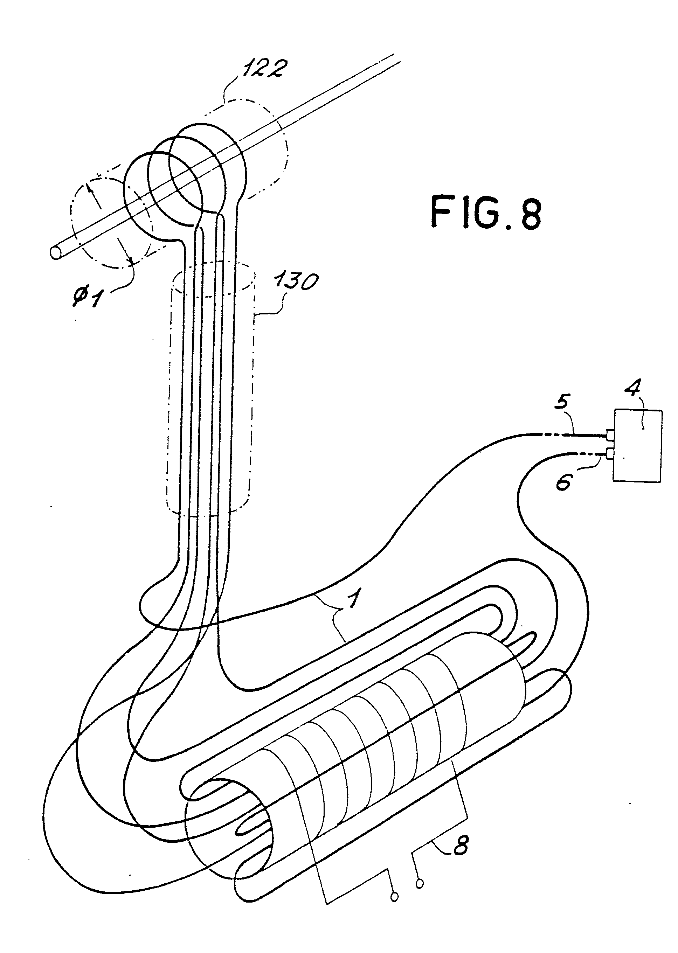

La figure 8 illustre un exemple simplifié d'un tel câblage dans lequel m = 3 et n = 2.

Si la bobine de contre-réaction 8 comporte p tours de fil électrique, le facteur de réduction du capteur est l/i = n.p. (indépendant de m).

La sensibilité du zéro du capteur obéit à la relation :

$$\frac{\Delta \alpha}{\Delta I} = m \cdot 10^{-5} \, A \, .$$

Outre l'application à la mesure du courant au sens strict du terme, le dispositif de l'invention peut également trouver application à la protection contre les surcharges. Dans ce cas, à l'aide de circuits électroniques simples à la portée de l'homme de métier, un signal est délivré lorsque l'intensité dépasse en amplitude une valeur prédéterminée et sert à déclencher des organes de sécurité.

Dans la première approche de dispositif selon l'invention qui vient d'être décrite l'isolateur remplit trois fonctions :

— protection et isolation de la descente d'informations d'une région à potentiel élevé à une région au potentiel de la terre (base 14)

— support mécanique du dispositif réducteur proprement dit contenu dans la tête

— support mécanique du tronçon de ligne 2 (ou de barre) situé de chaque côté de la tête de mesure 12 si le dispositif est autoporteur. Dans tous les cas, la ligne 2 et le support 13 étant soumis aux agressions naturelles, notamment au souffle du vent, il y a apparition de contrainte qui s'exerce sur le support 13. Or, l'élément utile dans la tête de mesure 12, constitué essentiellement par des spires de fibre optique et un mandrin sur lequel ces spires sont formées se réduit à quelques grammes, auxquels ont peut ajouter le faible poids de l'enveloppe de la tête de mesure 12. Le fort poids et les dimensions imposantes du support isolant 13 sont donc imposés par le fait que celui-ci doit aussi remplir une fonction non liée à la mesure proprement dite.

Une seconde approche de dispositif selon l'invention va maintenant être décrite.

Tout en conservant la structure générale qui vient d'être rappelée et les avantages qui y sont afférents, elle vise à en pallier les inconvénients résiduels, ce selon une caractéristique principale en simplifiant considérablement l'ensemble du système d'isolation, en diminuant son encombrement et son coût, et en rendant son exploitation plus aisée.

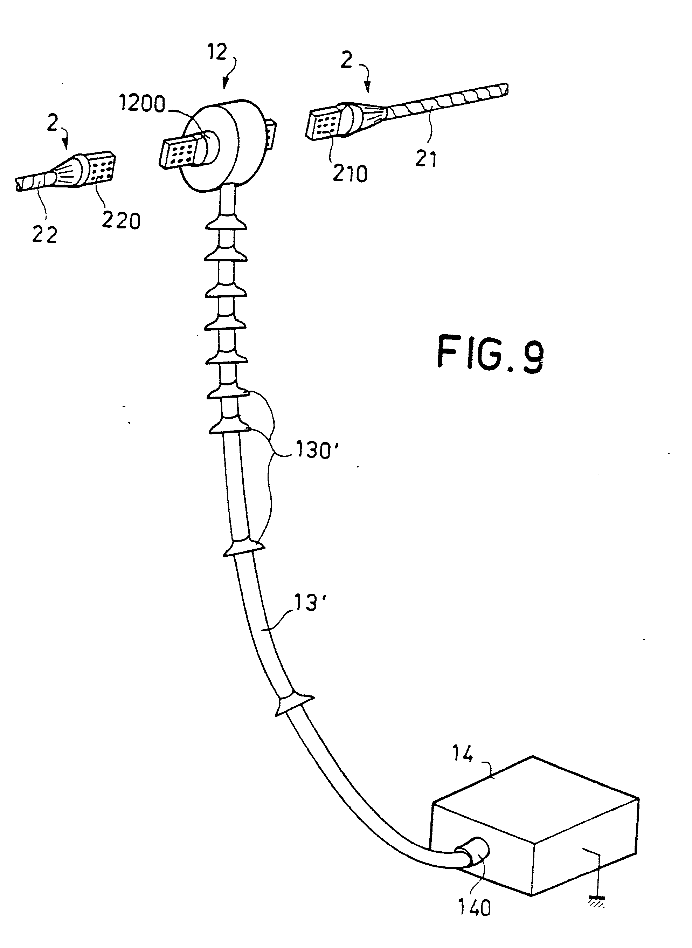

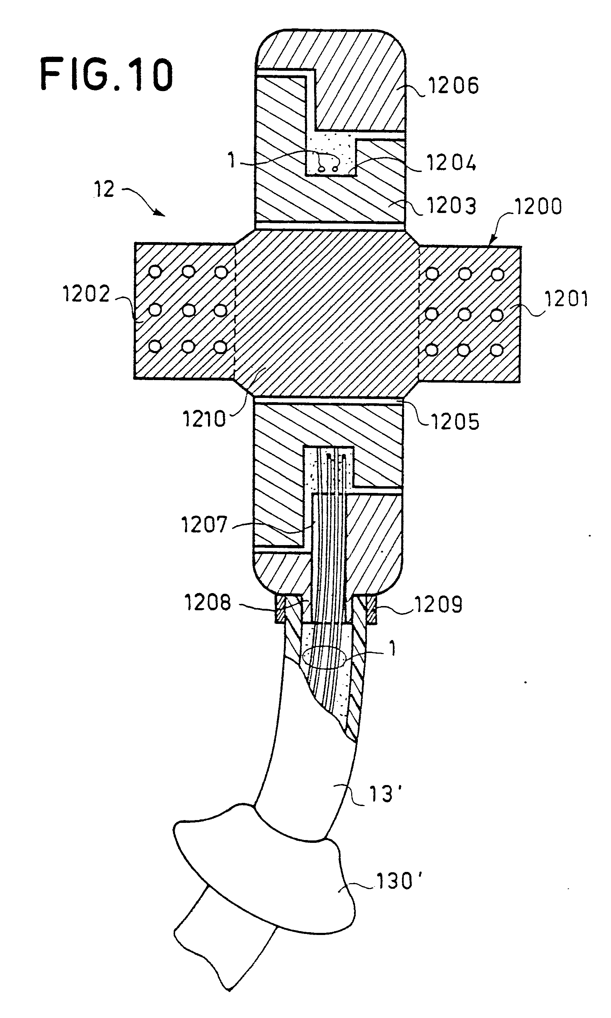

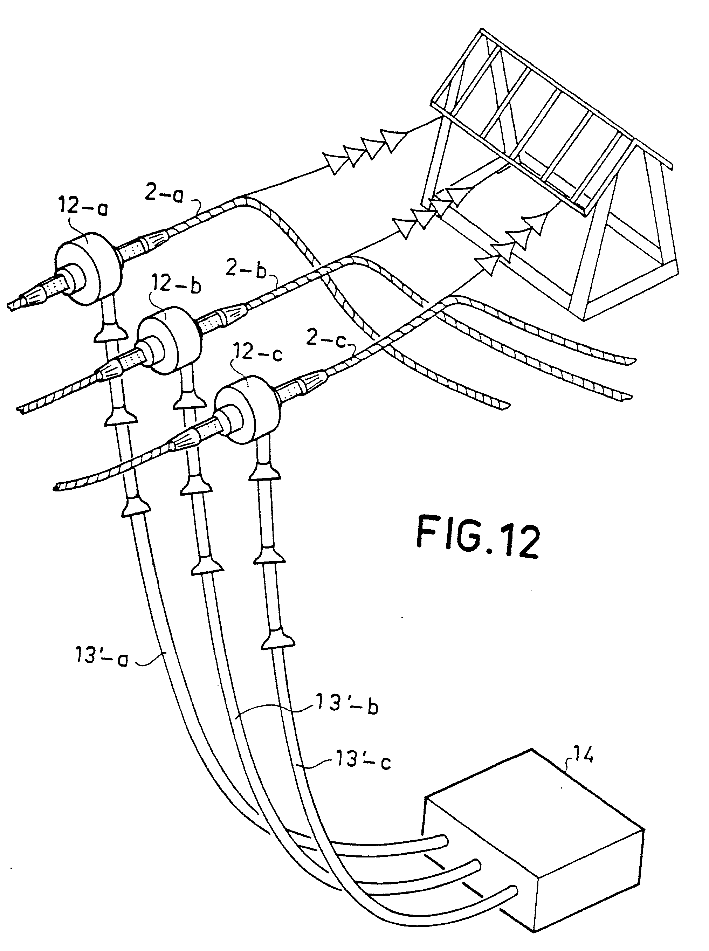

Les dispositions retenues dans le cadre de l'invention vont maintenant être décrites de façon détaillée en relation avec les figures 9 et 10.

La figure 9 est une vue d'ensemble du dispositif de mesure selon l'invention.

Il comprend, comme précédemment, trois ou quatre parties selon que les circuits électroniques sont intégrés ou non dans la base 14. Celle-ci est de même nature que celle qui vient d'être décrite en relation avec la figure 4. Cependant comme il va être explicité dans ce qui suit, ses dimensions peuvent être considérablement réduites, car la base n'a plus à soutenir un support isolant lourd et volumineux.

La différence principale est constituée par le fait que le support 13 (figure 4), rigide, est remplacé selon une caractéristique importante de la présente invention, par un élément tubulaire à paroi souple 13', en élastomère par exemple, éventuellement renforcé par des fibres en matériau diélectrique. Ces fibres peuvent être en verre, en silice ou en plastique, ou encore à base d'une combinaison de ces éléments. Cet élément tubulaire abrite le faisceau constitué par les allers et retours de la fibre 1. De façon préférentielle, la cavité constituée par le conduit intérieur du tube est remplie d'un isolant : gaz, par exemple de l'hexafluorure de soufre (SF$_6$) ; liquide, par exemple d'huile isolante d'utilisation classique, gel par exemple une graisse isolante ou gel de silicone ; ou encore solide élastique par exemple un autre élastomère ou du caoutchouc. Cette disposition présente les avantages suivants : assurer un meilleur maintien de la fibre optique 1, dans le cas des matériaux isolants de type gel ou solide élastique, et un renforcement de l'isolation dans tous les cas.

Enfin, de façon préférentielle, l'élément tubulaire isolant 13' est muni de jupes 130' à profil extérieur dit en « goutte d'eau » qui peuvent être fabriquées en même temps que celui-ci ou rapportées ultérieurement. Ces jupes peuvent être alors réalisées dans le même matériau élastomère que l'élément 13' ou à partir d'un autre matériau isolant, par exemple de la porcelaine. Leur rôle est d'augmenter la longueur de la ligne de fuite et d'assurer l'isolation même dans des conditions défavorables : pluie par exemple. L'élément 13' peut être muni de ces jupes 130' sur tout ou partie de sa longueur, ce avec une répartition uniforme ou non. Dans ce dernier cas, illustré sur la figure 3, la densité maximale de jupes 130' doit être réalisée à proximité de la tête de mesure qui est au potentiel de la ligne électrique.

La disposition qui vient d'être décrite peut encore être améliorée. Au lieu d'être muni de jupes distinctes, l'élément isolant 13' peut être muni d'une jupe unique 1300 comme illustré par la figure 5, autour de l'élément isolant en hélice. Le bord extérieur peut présenter comme précédemment un profil en forme de « goutte d'eau ». L'ensemble est de fabrication aisée et obtenu en une seule opération, par extrudage par exemple.

L'élément isolant souple 13' est connecté à l'embase 140 par tout moyen de fixation convenable, représenté sur la figure 3 sous la forme d'un collier 140.

La longueur de l'élément isolant peut être, dans un exemple de réalisation concrète, de l'ordre de 8 m pour une ligne électrique située à 5 m de hauteur.

On réalise que la souplesse de l'élément isolant tubulaire 13' permet d'épouser les mouvements de la ligne électrique sans les contraindre. En outre, l'embase (14) peut être disposée à un endroit quelconque, à la convenance des utilisateurs du dispositif, et non plus obligatoirement sous la ligne. La seule contrainte est que la distance la séparant de la ligne électrique soit supérieure à la distance d'isolement dans l'air.

En ce qui concerne la tête de mesure 2, bien que l'on puisse mettre en œuvre une tête analogue à celle qui a été décrite en relation avec la figure 4, il devient également possible grâce aux dispositions retenues dans cette approche d'en améliorer la structure en diminuant le poids et l'encombrement.

Dans une variante préférée, cette tête de mesure 2, illustrée en coupe sur la figure 10, comporte un élément de barre conductrice 1200, très courte. Cette barre, par exemple de section circulaire dans sa partie centrale 1210 sur laquelle sont enfilés les autres éléments de la tête de mesure, a une longueur typique de l'ordre de 50 mm et un diamètre de 125 mm pour cette partie centrale et se prolonge par deux plages de raccordement 1201 et 1202 planes destinées à être boulonnées sur des pièces correspondantes 210 et 220 des terminaisons amont 210 et aval de la ligne haute tension 2. Les plages 1201 et 1202 sont munies d'orifices destinés à recevoir des tiges filetées pour réaliser le boulonnage, en nombre et de diamètre déterminés par les caractéristiques physiques de la ligne à connecter.

La barre conductrice 1200 supporte un élément de forme torique, réalisé en matériau, isolant (par exemple de la résine époxy ou du polytétrafluoréthylène) ou non, et est constitué de deux demi-coques emboîtées l'une sur l'autre : 1203 et 1206 respectivement. La première demi-coque, 1203, comporte une gorge annulaire 1204 servant de mandrin pour les spires de la fibre optique 1 autour du circuit électrique dans lequel circule le courant à mesurer : la barre 1200 dans l'exemple de réalisation illustré par la figure 4.

La seconde demi-coque 1206, comporte un canal radial 1207 destiné à établir une communication entre l'élément isolant tubulaire à paroi souple 13' et la gorge annulaire 1204.

L'orifice extérieur de ce canal est prolongé par une collerette 1208 sur laquelle est enfilé l'élément tubulaire 13'. Des moyens de fixations de tous types convenables 1209, représentés sous la forme d'un collier sur la figure 4, sont également prévus.

L'ensemble a donc la triple fonction de servir de mandrin pour le bobinage de la fibre optique, de la protéger contre toutes les agressions mécaniques et contre les intempéries, ainsi que de servir de point d'attache pour l'élément tubulaire souple 13'.

Les deux demi-coques sont fixées entre elles par tous moyens convenables : boulonnage, soudure ou collage par exemple.

De façon préférentielle, les espaces internes laissés libres, notamment l'évidement annulaire 1204, sont remplis de matériau isolant, de façon analogue à ce qui a été décrit en relation avec l'élément tubulaire isolant 13'.

Pour des raisons de simplification de la représentation sur la figure 10 des éléments essentiels de la tête de mesure 12, il n'a été représenté que deux spires de la fibre optique 1 autour de la barre conductrice 1200. Il doit être bien entendu que le nombre de spires peut être quelconque.

Dans une autre variante, non illustrée, la tête peut être réalisée à partir d'une seule coque analogue à la coque 1203 comportant également une gorge annulaire dans laquelle sont enroulées les spires de la fibre 1. Ensuite la tête est complétée par un surmoulage, notamment par le remplissage de la gorge à l'aide d'un matériau isolant qui peut être le même que celui constituant la coque unique.

De façon préférentielle, le câblage de la fibre optique 1 ainsi que de l'enroulement de contre-réaction s'effectuera conformément au schéma décrit par référence à la figure 8.

Le coût et l'encombrement du dispositif de mesure de courant étant considérablement réduits par les dispositions qui viennent d'être décrites, il est encore possible de les réduire en remarquant que l'énergie électrique haute tension est le plus souvent délivrée sous forme polyphasée et notamment triphasée.

Classiquement, il est nécessaire de mettre en œuvre autant de dispositifs de mesure que de courants à mesurer, vu en particulier l'écartement important entre les différentes lignes haute tension véhiculant les courant polyphasés. La présente invention permet la mise en commun avec profit de certaines fonctions des dispositifs de mesure.

La figure 12 illustre une première possibilité de mise en commun, à savoir la mise en commun de l'embase 14 (et éventuellement des circuits électroniques 15 de la figure 4, s'ils sont séparés de l'embase). Cette disposition est notamment permise par la mise en œuvre d'éléments tubulaires isolants souples.

Sur la figure 12 est représentée une distribution de courant triphasée comportant trois câbles haute tension 2-a, 2-b et 2-c correspondant à des courants de phases repérées arbitrairement a, b et c. Sur ces trois câbles sont connectées en série, les barres de trois têtes de mesures 12-a, 12-b et 12-c, identiques, dans l'exemple de réalisation illustré par la figure 12, aux têtes de mesures décrites en relation avec les figures 9 et 10.

Trois descentes entre ces têtes et le boîtier unique de l'embase 14 sont assurées par trois éléments isolants tubulaires souples identiques : 13'-a, 13'-b et 13'-c respectivement. Cette disposition permet de mettre en commun les circuits électroniques (non représentés) nécessaires au traitement des signaux fournis par les trois interféromètres, chacun associé à une des trois têtes de mesures : 12-a, 12-b et 12-c ; ainsi que les circuits fournissant l'alimentation électrique, notamment des circuits de contre-réaction en courant (figure 1 : 8) de chaque interféromètre. Les trois courants, un par interféromètre, peuvent être dérivés, de façon simple, à partir d'une source unique.

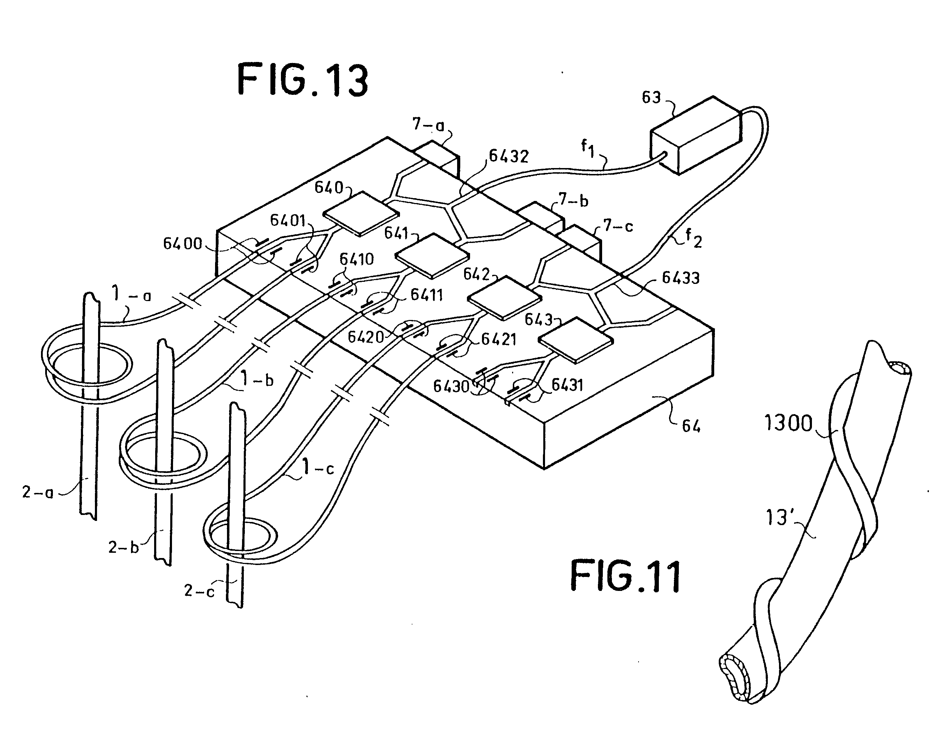

On peut cependant augmenter encore la compacité du dispositif, en mettant en commun une partie des circuits optiques. La figure 13 illustre cette possibilité.

Pour ce faire, le circuit intégré 4 de la figure 1 est remplacé par un circuit intégré comportant un substrat commun sur lequel ont été réalisés au moins trois circuits de séparation et de recombinaison, chacun de ces circuits étant associé à un interféromètre constitué par une fibre optique passant dans l'une des têtes de mesures 12-a à 12-c de la figure 11. Bien que de nombreux types de circuits intégrés puissent être mis en œuvre, on réalise celui-ci de façon préférentielle selon l'enseignement de la demande de brevet français FR-A-2 492 116. Comme illustré plus particulièrement aux figures 2 et 6 de cette demande de brevet, le circuit de séparation et de recombinaison est réalisé en créant dans le substrat, qui peut être une plaquette de Niobate de Lithium (LiNbO$_3$) ou de Tantalate de Lithium (LiTaO$_3$) des guides de lumière monomodes par diffusion d'ions métalliques (respectivement du Titanate et du Niobium). Dans l'application envisagée, chaque circuit comprend au moins cinq branches : deux branches d'entrée, deux branches de sortie et une branche centrale recouverte d'une métallisation, l'ensemble ayant la forme de deux Y disposés tête-bêche.

En outre, au moins une branche de sortie est munie d'un modulateur de phase analogue au modulateur 41 de la figure 1. Dans une réalisation préférée, chaque circuit est associé à deux modulateurs symétriques selon l'enseignement de la demande de brevet français FR-A-2 471 583, disposition plus particulièrement illustrée par la figure 15 de cette demande.

La figure 13 représente une configuration particulière de quatre coupleurs 640 à 643, formant un circuit intégré 64 (qui remplace le circuit intégré 4 de la figure 1). Chaque coupleur est associé à deux modulateurs : respectivement 6400-6401, 6410-6411, 6420-6421 et 6430-6431. En outre, deux coupleurs contigus comportent une branche d'entrée commune, respectivement 6432 et 6433. Cette disposition, pratique mais non obligatoire, permet une alimentation en énergie lumineuse plus aisée de deux coupleurs et par là de deux interféromètres. Dans le cas de la mesure de courants triphasés, un coupleur 643 reste disponible et peut être utilisé à d'autres fins ou à titre de réserve.

Les deux branches communes 6432 et 6433 sont couplées, via deux fibres optiques F$_1$ et F$_2$ à une source laser à semi-conducteur unique 63, l'une par la face avant, l'autre par la face arrière ; ce type d'élément optoélectronique, comme il est connu, émettant par les deux faces.

Les deux branches de sortie de chaque circuit de séparation et de recombinaison sont reliées aux extrémités de la fibre formant l'interféromètre qui leur est associé : respectivement 1-a, 1-b et 1-c, formant au moins une spire autour des conducteurs (figure 6 : 2-a, 2-b, 2-c) dans lesquels circulent les courants à mesurer.

Enfin, l'ensemble est complété par des détecteurs, respectivement 7-a, 7-b et 7-c, jouant un rôle analogue au détecteur 7 de la figure 1.

Les circuits électriques nécessaires sont analogues à ceux décrits en relation avec la figure 1.

Ils doivent être répétés trois fois et de façon plus générale x fois lorsque le nombre de phases différentes est x. Seul le circuit 11 est légèrement modifié, car il doit délivrer deux signaux de commande de même fréquence mais en opposition de phase pour alimenter les deux modulateurs qui lui sont associés, 6400 et 6401 par exemple pour le premier interféromètre (fibre 1-a).

L'invention n'est pas limitée aux seuls modes de réalisation précisément décrits et représentés, elle s'applique toutes les fois que l'on désire mesurer des courants véhiculés par des lignes hautes tensions, continus ou alternatifs, mono ou polyphasés.

(Voir Tableau I page 10)

9

Tableau I

| | |
|---|---|
| . ligne H.T.<br><br>    Tension<br><br>    Courant | 400 KV<br><br>63 KA |
| . facteur de réduction<br><br>. courant de contre-réaction | $10^5$<br><br>630 mA |
| . données géométriques<br><br>    n<br>    m<br>    P<br>    $\emptyset_1$<br><br>longueur du support 1 isolant<br><br>longueur totale de la fibre<br>optique L | <br><br>6<br>100<br>1000<br>500 mm<br><br>5 m<br><br><br>500 m (env.) |
| . sensibilité $\Delta \gamma / \Delta I$ | $10^{-4} rad.A^{-1}$ (env.) |
| . composants opto-électroniques<br><br>    . source de lumière<br><br><br>    . détecteur | <br><br>diode laser AsGa monomode<br>transverse<br><br>diode P.I.N. |

**Revendications**

1. Dispositif de mesure d'au moins un courant (I) circulant dans une ligne (2) de distribution d'énergie électrique portée à un potentiel élevé par rapport au potentiel de la terre du type mettant en œuvre au moins un organe de mesure interférométrique comprenant une fibre optique (1) dans laquelle circulent deux ondes en sens inverses, le courant à mesurer (I) induisant un premier déphasage ($\Delta\Phi_1$) entre les deux ondes émergeant aux extrémités (5, 6) de la fibre optique par effet Faraday, des circuits optoélectroniques (3, 7, 10, 11) délivrant un signal électrique de commande proportionnel à ce déphasage et un générateur (9) de courant de référence (i) alimentant un circuit conducteur de référence (8) induisant par effet Faraday un second déphasage ($\Delta\Phi_2$) entre les deux ondes émergeant aux extrémités (5, 6) de la fibre optique en sens contraire du premier déphasage et, d'amplitude telle que le déphasage résultant soit nul, la valeur du courant de référence (i) étant directement proportionnelle au courant à mesurer (I), dispositif caractérisé en ce qu'il comprend, pour chaque courant à mesurer, une tête de mesure (12) en matériau isolant enfilée sur un conducteur traversé par ledit courant (I) à mesurer, associé à chaque tête de mesure, un élément (13) en matériau isolant percé d'un canal de liaison (130), l'une des extrémités de ce canal débouchant dans la tête de mesure, et une embase (14) portée au potentiel de la terre comprenant ledit circuit de référence (8) et communiquant avec la seconde extrémité du canal (130) percé dans l'élément isolant (13), en ce que la fibre optique (1) de chaque organe de mesure interférométrique est disposée de manière à effectuer au moins une boucle fermée décrivant un trajet débutant dans l'embase (14), traversant le canal dans un premier sens, formant une spire autour dudit conducteur (2) à l'intérieur de la tête de mesure (12), retraversant le canal (130) en sens inverse et retournant dans l'embase (14) pour former au moins une spire autour dudit circuit conducteur de référence (8), et en ce que, la tête de mesure comprend deux demi-coquilles (120, 121) accolées en matériau isolant contenant un mandrin (122) enfilé sur ledit conducteur parcouru par le courant (I) à mesurer et sur lequel est enroulé au moins une spire de la fibre optique (1).

2. Dispositif selon la revendication 1, caractérisé en ce que la tête de mesure (12) a la forme d'un cylindre d'axe de symétrie parallèle au conducteur parcouru par le courant (I) à mesurer et prolongé aux deux extrémités par deux demi-sphères.

3. Dispositif selon la revendication 1, caractérisé en ce que la tête de mesure (12) a la forme d'une tore d'axe de symétrie parallèle au conducteur parcouru par le courant (I) à mesurer.

4. Dispositif selon la revendication 3, caractérisé en ce que chaque tête de mesure (12) comporte une barre (1200) en matériau conducteur prolongée à chaque extrémité par un membre plan (1201, 1202) muni de moyens de connexions de manière à être inséré en série avec une ligne dans laquelle circule le courant à mesurer, le tore étant enfilé sur ladite barre ; et en ce que le tore est muni d'une gorge annulaire (1204) interne dans laquelle s'enroule au moins une spire de ladite fibre optique (1) et communiquant par un canal radial (1207) avec l'élément (13') en matériau isolant ; ledit canal radial étant prolongé par une collerette (1208) sur laquelle est enfichée l'élément (13') en matériau isolant.

5. Dispositif selon la revendication 4, caractérisé en ce que le tore est en résine époxy.

6. Dispositif selon l'une quelconque des revendications 1 à 6, caractérisé en ce que le canal de l'élément (13') en matériau isolant et la gorge annulaire sont remplis d'un matériau isolant choisi parmi les suivants : gel isolant, solide élastique, huile ou hexafluorure de soufre sous pression plus forte que la pression atmosphérique.

7. Dispositif de mesure d'au moins un courant (I) circulant dans une ligne (2) de distribution d'énergie électrique portée à un potentiel élevé par rapport au potentiel de la terre du type mettant en œuvre au moins un organe de mesure interférométrique comprenant une fibre optique (1) dans laquelle circulent deux ondes en sens inverses, le courant à mesurer (I) induisant un premier déphasage ($\Delta\Phi_1$) entre les deux ondes émergeant aux extrémités (5, 6) de la fibre optique par effet Faraday, des circuits optoélectroniques (3, 7, 10, 11) délivrant un signal électrique de commande proportionnel à ce déphasage et un générateur (9) de courant de référence (i) alimentant un circuit conducteur de référence (8) induisant par effet Faraday un second déphasage ($\Delta\Phi_2$) entre les deux ondes émergeant aux extrémités (5, 6) de la fibre optique en sens contraire du premier déphasage et, d'amplitude telle que le déphasage résultant soit nul, la valeur du courant de référence (i) étant directement proportionnelle au courant à mesurer (I), dispositif caractérisé en ce qu'il comprend, pour chaque courant à mesurer, une tête de mesure (12) en matériau isolant enfilée sur un conducteur traversé par ledit courant (I) à mesurer, associé à chaque tête de mesure, un élément (13) en matériau isolant percé d'un canal de liaison (130), l'une des extrémités de ce canal débouchant dans la tête de mesure, et une emphase (14) portée au potentiel de la terre comprenant ledit circuit de référence (8) et communiquant avec la seconde extrémité du canal (130) percé dans l'élément isolant (13), en ce que la fibre optique (1) de chaque organe de mesure interférométrique est disposée de manière à effectuer au moins une boucle fermée décrivant un trajet débutant dans l'embase (14), traversant le canal dans un premier sens, formant une spire autour dudit conducteur (2) à l'intérieur de la tête de mesure (12), retraversant le canal (130) en sens inverse et retournant dans l'embase (14) pour former au moins une spire autour dudit circuit conducteur de référence (8), et en ce que, pour chaque tête de mesure, la fibre optique (1) décrit m fois un trajet débutant dans l'embase (14), traversant le canal (130) de l'élément isolant (13), formant une spire autour dudit conducteur (2) à l'intérieur de la tête de mesure (12), retraversant le canal (130) en sens inverse et formant n spires autour du circuit de référence (8) ; n et m étant des nombres entiers différents de zéro.

8. Dispositif selon l'une quelconque des revendications 1 à 7, caractérisé en ce que le conducteur parcouru par le courant (I) à mesurer est constitué par la ligne (2) de distribution d'énergie.

9. Dispositif selon l'une quelconque des revendications 1 à 7, caractérisé en ce que le conducteur parcouru par le courant (I) à mesurer est constitué par une barre (20) de matériau conducteur de l'électricité solidaire de la tête de mesure (12) et comportant des moyens de fixation (200, 201) permettant son insertion en série dans la ligne (2) de distribution d'énergie.

10. Dispositif selon l'une quelconque des revendications 1 à 9, caractérisé en ce que l'élément en matériau isolant est un élément tubulaire (13') à paroi souple muni d'une jupe unique (1300) en matériau isolant disposée en hélice autour de cet élément et en ce que le profil extérieur de cette jupe en hélice est arrondi en forme de « goutte d'eau ».

11. Dispositif selon l'une quelconque des revendications 1 à 10, caractérisé en ce que la distribution d'énergie électrique s'effectuant par des courants polyphasés véhiculés par des lignes particulières (2-a, 2-b, 2-c), il comprend un organe de mesure interférométrique comportant une fibre optique (1-a, 1-b, 1-c) et une tête de mesure (12-a, 12-b, 12-c) associées à chaque ligne particulière (2-a, 2-b, 2-c) et mesurant le courant véhiculé par cette ligne, une embase commune (14) et des éléments isolant tubulaires (13'-a, 13'-b, 13'-c) à parois souples reliant chacune desdites têtes de mesure à l'embase commune, ces éléments isolants tubulaires étant traversés par au moins un aller et retour de la fibre optique de l'organe interférométrique associée à la tête reliée de manière à ce que cette fibre forme au moins une spire autour de la ligne particulière associée (2-a, 2-b, 2-c).

12. Dispositif selon la revendication 11, caractérisé en ce que les extrémités de la fibre constituant chaque interféromètre sont reliées à des moyens de séparation et de recombinaison (640, 641, 642, 643), sont des ondes émergeant aux deux extrémités de la fibre optique par deux branches de sortie et en ce que ces moyens de séparation et de recombinaison sont réalisés sous forme de circuits optiques intégrés sur un substrat commun (64), ces moyens comportant en outre chacun deux branches d'entrée, une de ces branches étant couplée à des circuits opto-électroniques individuels (7-a, 7-b, 7-c) et l'autre à une source d'énergie lumineuse commune (63) ; et deux modulateurs de phase (6400-6401, 6410-6411, 6420-6421, 6430-6431) alimentés par des signaux en opposition de phase associé chacun à une des deux branches de sortie.

13. Dispositif selon la revendication 12, caractérisé en ce que l'une des branches d'entrée de deux moyens de séparation et de recombinaison contigus (640-641, 642-643) sur ledit substrat commun (64) forment un tronc commun (6432, 6433) et en ce que la source d'énergie commune (63) étant constituée par un laser semiconducteur, chaque tronc commun est couplé optiquement à l'une des faces émissives, avant ou arrière de ce laser par une fibre optique ($f_1$, $f_2$).

14. Dispositif selon l'une quelconque des revendications 11 à 14, caractérisé en ce que la distribution d'énergie électrique s'effectue par trois lignes (2-a, 2-b, 2-c) véhiculant des courants triphasés.

**Claims**

1. Device for measuring at least one current (I) circulating within an electric energy distribution line (2) having a high potential in relation to ground potential, of the type using at least one interferometer probe comprising an optical fiber (1) wherein two waves circulate in opposite senses, the current (I) to be measured inducing a first phase shift ($\Delta\Phi_1$) by the Faraday effect between the two waves emerging at the ends (5, 6) of the optical fiber, optoelectronic circuits (3, 7, 10, 11) supplying an electric control signal proportional to this phase shift and a reference (i) current generator (9) supplying a reference conductor circuit (8) inducing by the Faraday effect a second phase shift ($\Delta\Phi_2$) between the two waves emerging at the ends (5, 6) of the optical fiber of a sense opposite to that of the first phase shift and having an amplitude of such value that the resulting phase shift is zero, the value of the reference current (i) being directly proportional to the current (I) to be measured, the device being characterized in that it comprises for each current to be measured a probe head (12) of insulating material threaded onto a conductor crossed by said current (I) to be measured, associated with each probe head, an element (13) of insulating material pierced by a connection channel (130), one of the ends of this channel opening into the probe head, and a base (14) connected to ground potential and comprising said reference circuit (8) and communicating with the second end of the channel (130) pierced through the insulating element (13), in that the optical fiber (1) of each interferometer probe is arranged in such a manner as to form at least one closed loop along a path beginning in the base (14), crossing the channel in a first sense, forming a turn around said conductor (2) inside of the probe head (12), crossing the channel (130) again in opposite sense and returning into the base (14) to form at least one turn around said reference circuit conductor (8), and in that the probe head comprises two joined half-cups (120, 121) of insulating material and containing a mandrel (122) threaded onto said conductor crossed by the current (I) to be measured and whereabout at least one turn of the optical fiber (1) is wound.

2. Device according to claim 1, characterized in that the probe head (12) is of cylindrical shape with an axis of symmetry lying parallel to the conductor crossed by the current (I) to be measured, and is extended at both ends by two half-spheres.

3. Device according to claim 1, characterized in that the probe head (12) is of toroidal shape with an axis of symmetry lying parallel to the conductor crossed by the current (I) to be measured.

4. Device according to claim 3, characterized in that each probe head (12) comprises a rod (1200) of conductive material extended at each end by a plane member (1201, 1202) provided with connection means in such a manner as to be insertable in series with a line wherein the current to be measured circulates, the toroid being threaded onto said rod ; and in that the toroid is provided with an internal annular groove (1204) wherein at least one turn of said optical fiber (1) is wound, and communicating through a radial channel (1207) with the element (13') of insulating material ; said radial channel being extended by a collar (1208) whereupon the element (13') of insulating material is threaded.

5. Device according to claim 4, characterized in that the toroid is of epoxy resin.

6. Device according to any of claims 1 to 6, characterized in that the channel of the element (13') of insulating material and the annular groove are filled with an insulating material selected among the following : insulating gel, resilient solid, oil or sulphur hexafluoride under a pressure exceeding atmospheric pressure.

7. Device for the measurement of at least one current (I) circulating within an electric energy distribution line (2) connected to a high potential in relation to ground potential, of the type using at least one interferometer probe comprising an optical fiber (1) wherein two waves circulate in opposite senses, the current (I) to be measured inducing by the Faraday effect a first phase shift ($\Delta\Phi_1$) between the two waves emerging at the ends (5, 6) of the optical fiber, optoelectronic circuits (3, 7, 10, 11) supplying an electric control signal proportional to this phase shift and a reference (i) current generator (9) supplying a reference conductor (8) inducing by the Faraday effect a second phase shift ($\Delta\Phi_2$) between the two waves emerging at the ends (5, 6) of the optical fiber in a sense contrary to that of the first phase shift and having an amplitude of such value that the resulting phase shift is zero, the value of the reference current (i) being directly proportional to the current (I) to be measured and the device being characterized in that it comprises, for each current to be measured, a probe head (12) of insulating material threaded onto a conductor crossed by that current (I) to be measured, associated with each probe head an element (13) of insulating material pierced by a connection channel (130), one of the ends of this cannel opening into the probe head, and a base (14) connected to ground potential and comprising said reference circuit (8) and communicating with the second end of the channel (130) formed through the insulating element (13), in that the optical fiber (1) of each interferometer probe is arranged in a manner to form at least one closed loop along a path beginning in the base (14), crossing the channel in a first sense, forming a turn around said conductor (2) inside of the probe head (12), crossing the channel (130) again in the opposite sense and returning into the base (14) to form at least one turn around said reference conductor circuit (8), and in that the optical fiber (1) of each probe head follows m times a path beginning in the base (14), crossing the channel (130) of the insulating element (13) forming a turn around said conductor (2) inside of the probe head (12), crossing the channel (130) again in the opposite sense and forming n turns about the reference circuit (8) ; n and m being integers different from zero.

8. Device according to any of claims 1 to 7, characterized in that the conductor crossed by the current (I) to be measured is formed by the energy distribution line (2).

9. Device according to any of claims 1 to 7, characterized in that the conductor crossed by the current (I) to be measured is formed by a rod (20) of electrically conductive material secured to the probe head (12) and comprising connection means (200, 201) permitting its insertion in series with the energy distribution line (2).

10. Device according to any of claims 1 to 9, characterized in that the element of insulating material is a tubular element (13') having a flexible wall provided with a single skirt (1300) of insulating material which is helically arranged about said element, and in that the outer profile of this helical skirt is rounded in drop shape.

11. Device according to any of claims 1 to 10, characterized in that the distribution of the electric energy is performed through polyphase currents carried by particular lines (2-a, 2-b, 2-c), the device comprising an interferometer probe including an optical fiber (1-a, 1-b, 1-c) and a probe head (12-a, 12-b, 12-c) associated with each particular line (2-a, 2-b, 2-c) and measuring the current carried by this line, a common base (14) and tubular insulating elements (13'-a, 13'-b, 13'-c) having flexible walls and connecting each of said probe head to the common base, these insulating tubular elements being crossed by at least one forward and one backward path of the optical fiber of the interferometer probe associated with the head connected in such a manner that this fiber forms at least one turn about the particular associated line (2-a, 2-b, 2-c).

12. Device according to claim 11, characterized in that the ends of the fiber forming each interferometer are connected to separating and recombination means (640, 641, 642, 643), the waves emerging at the two ends of the optical fiber through two output branches, and in that these separating and recombination means are formed as optical circuits integrated on a common substrate (64) each of these means further comprising two input branches, one of the branches being coupled to individual optoelectronic circuits (7-a, 7-b, 7-c) and the other to a common light energy source (63) ; and two phase modulators (6400-6401, 6410-6411, 6420-6421, 6430-6431) supplied by opposite phase signals and each associated with one of the two output branches.

13. Device according to claim 12, characterized in that one of the input branches of two adjacent separating and recombination means (640-641, 642-643) on said common substrate (64) form a common cord (6432, 6433) and in that the common energy source (63) is formed by a semiconductor laser, each

0 089 275

common cord being optically coupled to one of the emitting faces, front or rear face, of this laser by an optical fiber ($f_1$, $f_2$).

14. Device according to any of claims 11 to 14, characterized in that the electric energy distribution is performed through three lines (2-a, 2-b, 2-c) carrying three-phase currents.


**Patentansprüche**

1. Vorrichtung zur Messung wenigstens eines Stromes (I), der in einer elektrischen Stromversorgungsleitung (2) fließt, die auf einem hohen Potential gegenüber dem Massepotential liegt, unter Anwendung wenigstens eines Interferometer-Meßorgans, welches eine optische Faser (1) umfaßt, worin zwei Wellen in entgegengesetzten Richtungen umlaufen, wobei der zu messende Strom (I) eine erste Phasenverschiebung ($\Delta\Phi_1$) durch den Faraday-Effekt zwischen den zwei Wellen verursacht, die an den Enden (5, 6) der optischen Faser auftreten, optoelektronische Schaltungen (3, 7, 10, 11) umfaßt, welche ein elektrisches Steuersignal abgeben, das proportional zu dieser Phasenverschiebung ist, und einen Referenz (i)-Stromgenerator (9) enthält, welcher einen Referenz-Leiterkreis (8) speist, indem durch den Faraday-Effekt eine zweite Phasenverschiebung ($\Delta\Phi_2$) zwischen den zwei Wellen hervorgerufen wird, welche an den Enden (5, 6) der optischen Faser austreten, in entgegengesetztem Sinne wie die erste Phasenverschiebung und von einer solchen Größe, daß die resultierende Phasenverschiebung gleich Null ist, wobei der Wert des Referenzstromes (i) direkt proportional zu dem zu messenden Strom (I) ist, und wobei die Vorrichtung dadurch gekennzeichnet ist, daß sie für jeden zu messenden Strom einen Meßkopf (12) aus einem Isoliermaterial umfaßt, welcher auf einen Leiter aufgeschoben ist, der von dem genannten zu messenden Strom (I) durchquert wird, der dem jeweiligen Meßkopf zugeordnet ist, ein Element (13) aus Isoliermaterial umfaßt, welches von einem Verbindungskanal (130) durchdrungen wird, wobei das eine Ende dieses Kanales in den Meßkopf einmündet, und einen auf das Massepotential gelegten Sockel (14) umfaßt, welcher den genannten Referenzkreis (8) enthält und mit dem zweiten Ende des Kanales (130) in Verbindung steht, der durch das Isolierelement (13) hindurch angeordnet ist, daß die optische Faser (1) jedes Interferometer-Meßorgans derart angeordnet ist, daß wenigstens eine geschlossene Schleife gebildet wird, die einen Weg beschreibt, der am Sockel (14) beginnt, den Kanal in einem ersten Sinne durchquert, eine Windung um den genannten Leiter (2) herum im Inneren des Meßkopfes (12) bildet, den Kanal (130) im entgegengesetzten Sinne wieder durchquert und zum Sockel (14) zurückführt, um wenigstens eine Windung um den genannten Referenz-Kreis (8) herum zu bilden, und daß der Meßkopf zwei aneinandergefügte Halbschalen (120, 121) aus Isoliermaterial umfaßt, die einen Dorn (122) enthalten, welcher über den genannten von dem zu messenden Strom (I) durchflossenen Leiter geschoben ist und auf den wenigstens eine Windung der optischen Faser (1) aufgewickelt ist.

2. Vorrichtung nach Anspruch 1, dadurch gekennzeichnet, daß der Meßkopf (12) die Form eines Zylinders aufweist, dessen Symmetrieachse parallel zu dem vom zu messenden Strom (I) durchflossenen Leiter ist und welcher an den beiden Enden durch zwei Halbkugeln verlängert ist.

3. Vorrichtung nach Anspruch 1, dadurch gekennzeichnet, daß der Meßkopf (12) die Form eines Torus aufweist, dessen Symmetrieachse parallel zu dem vom zu messenden Strom (I) durchflossenen Leiter ist.

4. Vorrichtung nach Anspruch 3, dadurch gekennzeichnet, daß jeder Meßkopf (12) einen Stab (1200) aus leitfähigem Material umfaßt, welcher an jedem Ende durch ein ebenes Teil (1201, 1202) verlängert ist, das mit Anschlußmitteln versehen ist, dergestalt, daß er in Reihe mit einer Leitung eingefügt ist, worin der zu messende Strom fließt, wobei der Torus über den genannten Stab geschoben ist ; und daß der Torus mit einer internen ringförmigen Nut (1204) versehen ist, in welche wenigstens eine Windung der genannten optischen Faser (1) eingerollt ist und die über einen radialen Kanal (1207) mit dem Element (13') aus Isoliermaterial in Verbindung ist ; wobei der radiale Kanal durch einen Kragen (1208) verlängert ist, worauf das Element (13') aus Isoliermaterial aufgeschoben ist.

5. Vorrichtung nach Anspruch 4, dadurch gekennzeichnet, daß der Torus aus Epoxyharz ist.

6. Vorrichtung nach einem der Ansprüche 1 bis 6, dadurch gekennzeichnet, daß der Kanal des Elementes (13') aus Isoliermaterial und die ringförmige Nut durch ein Isoliermaterial ausgefüllt sind, das unter folgenden ausgewählt ist : Isoliergel, elastischer Feststoff, Öl oder Schwefelhexafluorid unter einem Druck, der größer ist als der Atmosphärendruck.

7. Vorrichtung zur Messung wenigstens eines Stromes (I), welcher in einer elektrischen Stromversorgungsleitung (2) fließt, die auf einem hohen Potential gegenüber dem Massepotential liegt, vom Typ mit wenigstens einem Interferometer-Meßorgan, das eine optische Faser (1) aufweist, worin zwei Wellen in entgegengesetzten Richtungen umlaufen, wobei der zu messende Strom (I) eine erste Phasenverschiebung ($\Delta\Phi_1$) durch den Faraday-Effekt zwischen den zwei Wellen erzeugt, welche an den Enden (5, 6) der optischen Faser austreten, optoelektronische Schaltungen (3, 7, 10, 11) umfaßt, welche ein elektrisches Steuersignal abgeben, das proportional zu dieser Phasenverschiebung ist, und einen Referenz (i)-Stromgenerator (9) umfaßt, welcher einen Referenz-Leiterkreis (8) speist, der durch den Faraday-Effekt eine zweite Phasenverschiebung ($\Delta\Phi_2$) zwischen den zwei an den Enden (5, 6) der optischen Faser austretenden Wellen in entgegengesetztem Sinne wie die erste Phasenverschiebung und mit einer solchen Amplitude verursacht, daß die resultierende Phasenverschiebung gleich Null ist, wobei

14

der Wert des Referenz-Stromes (i) direkt proportional zu dem zu messenden Strom (I) ist und wobei die Vorrichtung dadurch gekennzeichnet ist, daß sie umfaßt : für jeden zu messenden Strom einen Meßkopf (12) aus Isoliermaterial, welcher auf einen von dem genannten zu messenden Strom (I) durchquerten Leiter aufgeschoben ist, jedem Meßkopf zugeordnet ein Element (13) aus Isoliermaterial, das von einem Verbindungskanal (130) durchdrungen wird, wobei das eine Ende dieses Kanals in den Meßkopf einmündet, und einen Sockel (14), welcher auf das Massepotential gelegt ist und den genannten Referenz-Kreis (8) umfaßt sowie mit dem zweiten Ende des Kanals (130), der in dem Isolierelement (13) gebildet ist, in Verbindung steht, daß die optische Faser (1) jedes Interferrometer-Meßorgans dergestalt angeordnet ist, daß sie wenigstens eine geschlossene Schleife bildet, die einen Weg beschreibt, welcher im Sockel (14) beginnt, den Kanal in einem ersten Sinne durchquert, eine Windung um den genannten Leiter (2) herum im Inneren des Meßkopfes (12) bildet, den Kanal (130) im entgegengesetzten Sinne wieder durchquert und in den Sockel (14) zurückführt, um wenigstens eine Windung um den Referenz-Leiterkreis (8) herum zu bilden, und daß die optische Faser (1) für jeden Meßkopf m mal einen Weg beschreibt, welcher in dem Sockel (14) beginnt, den Kanal (130) des Isolierelementes (13) durchquert, eine Windung um den genannten Leiter (2) herum im Inneren des Meßkopfes (12) bildet, den Kanal (130) wieder im entgegengesetzten Sinne durchquert und n Windungen um den Referenz-Kreis (8) herum bildet ; wobei n und m ganze Zahlen sind, die von Null verschieden sind.

8. Vorrichtung nach einem der Ansprüche 1 bis 7, dadurch gekennzeichnet, daß der von dem zu messenden Strom (I) durchflossene Leiter durch die Stromversorgungsleitung (2) gebildet ist.

9. Vorrichtung nach eine, der Ansprüche 1 bis 7, dadurch gekennzeichnet, daß der von dem zu messenden Strom (I) durchflossene Leiter durch einen Stab (20) aus elektrisch leitfähigem Material gebildet ist, welcher mit dem Meßkopf (12) fest verbunden ist und Befestigungsmittel (200, 201) umfaßt, die seine Einfügung in Reihe mit der Stromversorgungsleitung (2) gestatten.

10. Vorrichtung nach einem der Ansprüche 1 bis 9, dadurch gekennzeichnet, daß das Element aus Isoliermaterial ein rohrförmiges Element (13') mit nachgiebiger Wandung ist, welches eine Schürze (1300) aus Isoliermaterial aufweist, die schraubenförmig um das Element herum angeordnet ist, und daß das Außenprofil dieser schraubenförmigen Schürze tropfenförmig gerundet ist.

11. Vorrichtung nach einem der Ansprüche 1 bis 10, dadurch gekennzeichnet, daß die Stromverteilung über mehrphasige Ströme erfolgt, welche über besondere Leitungen (2-a, 2-b, 2-c) fließen, und die Vorrichtung ein Interferometer-Meßorgan umfaßt, welches eine optische Faser (1-a, 1-b, 1-c) und einen Meßkopf (12-a, 12-b, 12-c) umfaßt, welche jeweils einer der besonderen Leitungen (2-a, 2-b, 2-c) zugeordnet sind und den über diese Leitung fließenden Strom messen, einen gemeinsamen Sockel (14) und rohrförmige Isolierelemente (13'-a, 13'-b, 13'-c) mit flexiblen Wandungen umfaßt, welche jeweils einen der Meßköpfe mit dem gemeinsamen Sockel verbinden, wobei diese rohrförmigen Isolierelemente durchquert sind von wenigstens einem Hin- und Rückweg der optischen Faser des Interferometer-Organes, welches dem Kopf zugeordnet ist, die derart angeschlossen ist, daß diese Faser wenigstens eine Windung um die besondere zugeordnete Leitung (2-a, 2-b, 2-c) herum bildet.

12. Vorrichtung nach Anspruch 11, dadurch gekennzeichnet, daß die Enden der jedes Interferometer bildenden Faser an Trenn- und Rekombinationsmittel (640, 641, 642, 643) angeschlossen sind, bei welchen an den zwei Enden der optischen Faser die Wellen über zwei Austrittszweige austreten, und daß diese Trenn- und Rekombinationsmittel in Form von optischen Schaltungen verwirklicht sind, welche auf einem gemeinsamen Substrat (64) integriert sind, wobei diese Mittel ferner jeweils zwei Eingangszweige umfassen, wovon der eine an individuelle optoelektronische Schaltungen (7-a, 7-b, 7-c) und der andere an eine gemeinsame Lichtenergiequelle (63) angekoppelt ist ; und zwei Phasenmodulatoren (6400-6401, 6410-6411, 6420-6421, 6430-6431) umfassen, welche durch die Signale mit entgegengesetzter Phasenlage gespeist werden und jeweils einem der Ausgangszweige zugeordnet sind.

13. Vorrichtung nach Anspruch 12, dadurch gekennzeichnet, daß einer der Eingangszweige von zwei Trenn- und Rekombinationsmitteln (640-641, 642-643), die auf dem gemeinsamen Substrat (64) nebeneinander liegen, einen gemeinsamen Strang (6432, 6433) bilden und daß die gemeinsame Energiequelle (63) durch einen Halbleiterlaser gebildet ist, wobei jeder gemeinsame Strahl optisch an eine der Austrittsflächen, die vordere oder die hintere Austrittsfläche, dieses Lasers über eine optische Faser ($f_1$, $f_2$) angekoppelt ist.

14. Vorrichtung nach einem der Ansprüche 11 bis 14, dadurch gekennzeichnet, daß die elektrische Stromversorgung über drei Leitungen (2-a, 2-b, 2-c) erfolgt, die Dreiphasenströme befördern.

FIG.1

FIG.2

FIG.3

FIG. 4

FIG.5

FIG.6

FIG.7

FIG.8

FIG.9

# FIG.10

FIG.12

# FIG.13

# FIG.11